(19) Europäisches Patentamt European Patent Office Office européen des brevets

(11) **EP 1 975 688 A1**

(12) **EUROPEAN PATENT APPLICATION**

(43) Date of publication:
01.10.2008 Bulletin 2008/40

(51) Int Cl.:
*G02F 1/1345* (2006.01)

(21) Application number: 07119848.5

(22) Date of filing: 02.11.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: 22.03.2007 KR 20070028094

(71) Applicant: **Samsung SDI Co., Ltd.**
**Suwon-si**
**Gyeonggi-do (KR)**

(72) Inventor: **Lee, Byong-Gon**
**Yeongtong-gu, Suwon-si, Gyeonggi-do (KR)**

(74) Representative: **Hengelhaupt, Jürgen et al**
**Anwaltskanzlei**
**Gulde Hengelhaupt Ziebig & Schneider**
**Wallstrasse 58/59**
**10179 Berlin (DE)**

Remarks:
Amended claims in accordance with Rule 137(2) EPC.

(54) **Flat panel display**

(57) A flat panel display to maintain resistance of lines at the same level to reduce a luminance difference between the lines includes a plurality of electrodes (14) and a plurality of lead lines (36) to respectively connect a plurality of pads (34) to the plurality of electrodes (14). The lead lines (36) are formed in a parallelogram shape in which resistivity and line thickness are the same for each lead line, and a length L and a line width W of each lead line are selected such that a value obtained by dividing the length L by the line width W satisfies the equation:

$$\frac{L_1}{W_1} = \frac{L_2}{W_2} = \frac{L_3}{W_3} = \ldots\ldots = \frac{L_n}{W_n},$$

where L1, L2, L3, ..., and Ln respectively refers to long side lengths, which are direct line distances between the electrode (14) and the pad (34), of the respective lead lines (36) formed in the parallelogram shape, and W1, W2, W3, . , and Wn respectively refers to widths, which are short side distances of the respective lead lines (36) formed in the parallelogram shape.

*FIG.3*

**Description**

**BACKGROUND OF THE INVENTION**

**1. Field of the Invention**

Aspects of the present invention relate to a flat panel display. More particularly, aspects of the present invention relate to an electrode pattern of a flat panel display.

**2. Description of the Related Art**

Generally, a flat panel display (FPD) includes front and rear substrates that are combined to form a closed and sealed container having a predetermined inner space. A structure to emit light of a predetermined color from each pixel is provided in the sealed container so as to realize or display an image.

There are various types of flat panel displays, including a liquid crystal display (LCD), a plasma display panel (PDP), a vacuum fluorescent display, an electron emission display, and an organic light emitting diode (OLED) display. Since a flat panel display includes an electrode for driving the flat panel display, the electrode is formed on the front substrate or the rear substrate in a predetermined pattern. An end portion thereof is connected to a pad connected to a flexible printed circuit board (FPCB) and a printed circuit board assembly to apply an external driving voltage to the electrode.

One type of an electron emission display is a field emitter array (FEA) type electron emission display. The field emitter array (FEA) type electron emission display includes a cathode and a gate electrode formed on a first substrate (e.g., a rear substrate), and an anode formed on a second substrate (e.g., a front substrate) that face the first substrate. In addition, pads that are connected to the cathode, the gate electrode, and the anode are formed on an edge part of the first substrate and the second substrate, and the pads are formed in a predetermined pattern corresponding to a pattern of the printed circuit board assembly.

Generally, a part to connect each electrode to the corresponding pad is referred to as a lead line. The lead line has a line width that is equal to that of the pad. Accordingly, each electrode is electrically connected to the respective pad. In addition, the electrodes are formed on the substrate with a line pattern to have a pitch that corresponds to a width and a length of the substrate, but the pad is formed on the substrate with a different pitch from that of the electrode to take account of a configuration of the printed circuit board assembly. Accordingly, the dimension of the width of the electrode and the dimension of the width of the pad are different after the electrode and the pad are formed on the substrate, and the dimensions of the widths of the electrodes and pads forming one group are different after a plurality of electrodes and pads are formed. With this configuration, among the electrodes forming the one group, an electrode is connected to one corresponding pad via a lead line that extends straight, but another electrode is connected to another corresponding pad via a lead line that extends at a relative incline. With both types of lead lines, the width of each lead line is maintained to be the same as that of the corresponding pad. Accordingly, the respective lead lines of electrodes forming the group have length differences based on positions thereof, and resistance values of the lead lines are different from one another. Therefore, voltage values supplied to the respective electrodes may not be maintained at a predetermined level. In addition, since a voltage of a predetermined level may not be uniformly supplied to electron emission units corresponding to the respective electrodes, the amount of electrons emitted from the respective electron emission units varies. Therefore, luminance of the display device may not be uniform for each pixel.

**SUMMARY OF THE INVENTION**

Aspects of the present invention have been made to provide a flat panel display that supplies a predetermined voltage to each electrode through a lead line, and/or other advantages.

A flat panel display according to an aspect of the present invention includes a plurality of electrodes, a plurality of pads, and a plurality of lead lines to respectively connect the plurality of pads to the plurality of electrodes. The lead lines are formed in a parallelogram shape in which resistivity and line width are the same for each, and a length L and a line width W of each lead line are selected such that a value obtained by dividing the length L by the line width W may satisfy the equation

$$\frac{L_1}{W_1} = \frac{L_2}{W_2} = \frac{L_3}{W_3} = \ldots\ldots = \frac{L_n}{W_n},$$

where $L_1$, $L_2$, $L_3$, ..., and $L_n$ respectively refer to long side lengths, which are direct line distances between the corresponding electrode and the corresponding pad, of the respective lead lines formed in the parallelogram shape, and $W_1$, $W_2$, $W_3$, ..., and $W_n$ respectively refer to widths, which are short side distances of the respective lead lines formed in the parallelogram shape). Length L and line width W of each lead line are selected such that the ratio L/W is the same for all lead lines in a bundle.

Preferably each of the plurality of lead lines has a longish shape, more particularly each of the plurality of lead lines is line-shaped. The length of each lead line is measured along the longitudinal axis of said lead line, the width of each lead line is measured along an axis which is perpendicular to the longitudinal axis of said lead line but parallel to the (preferably planar) surface on which said lead line is located, and the thickness of each lead line is measured along an axis which is perpendicular to the longitudinal axis of said lead line and perpendicular to the (preferably planar) surface on which said lead line is located.

Preferably the each of the plurality of lead lines directly contacts both, the respective one of the plurality of electrodes and the respective one of the plurality of pads.

Preferably the thickness of the lead lines (i.e. the elevation of lead lines over the surface on which they are placed) is uniform and/or preferably the thickness of all the lead lines is equal.

The plurality of electrodes may be grouped into bundles, and the number of lead lines per bundle may preferably range from 2 to 100, more preferably from 4 to 10.

Preferably the end portions of the plurality of electrodes are connected to end portions of respective pad (via lead lines), wherein opposite end portions of the respective pads are connected to a flexible printed circuit board (FPCB), and the flexible printed circuit board is connected to a printed circuit board assembly which is adapted to generate and/or apply an external driving voltage to the electrode.

Preferably the electrodes are formed on a substrate parallel to each other with a line pattern to have a pitch that corresponds to a width and a length of the substrate, and the pads are formed parallel to each other on the substrate with a different pitch from that of the electrode to take account of a configuration of the printed circuit board assembly. Preferably the pitch of the electrodes is larger than the pitch of the pads.

Preferably the plurality of pads, the plurality of electrodes and the plurality of lead lines are locted on the (same) substrate of the flat panel display.

Preferably each of the plurality of electrodes extends over at least 70% of the respective side length of the substrate (to which the electrode is parallel).

In an aspect of the present invention, a line width $Wn$ of the one lead line is selected to satisfy the equation $Wn=W_0 \sec\theta n$, where $W_0$ refers to a minimum line width of the one lead line when an inclination angle $\theta$ is 0 between the one lead line and an extension line of the corresponding electrode, and $\theta n$ refers to an inclination angle $\theta$ of the one lead line and the extension line of the corresponding electrode of the one lead line.

In addition, a flat panel display according to an aspect of the present invention includes first and second substrates, an electron emission unit, a plurality of lead lines, and a light emitting unit. The first and second substrates face each other. The electron emission unit is disposed on one surface of the first substrate and includes a plurality of electrodes and a plurality of pads. The plurality of lead lines respectively connects the plurality of pads to the plurality of electrodes. The light emitting unit is disposed on one surface of the second substrate. The lead lines are formed in a parallelogram shape in which resistivity and line width are the same for each, and a length L and a line width W of each lead line are selected such that a value obtained by dividing the length L by the line width W may satisfy the equation

$$\frac{L_1}{W_1} = \frac{L_2}{W_2} = \frac{L_3}{W_3} = \ldots\ldots = \frac{L_n}{W_n},$$

where $L_1$, $L_2$, $L_3$, ..., and $Ln$ respectively refer to long side lengths, which are direct line distances between the corresponding electrode and the corresponding pad, of the respective lead lines formed in the parallelogram shape, and $W_1$, $W_2$, $W_3$, ..., and $Wn$ respectively refer to widths, which are short side distances of the respective lead lines formed in the parallelogram shape).

A line width $Wn$ of one of the lead lines may be selected to satisfy the equation $Wn = W_0 \sec\theta n$, where $W_0$ refers to a minimum line width of the one lead line when an inclination angle $\theta$ is 0 between the one lead line and an extension line of the corresponding electrode, and $\theta n$ refers to an inclination angle $\theta$ of the one lead line and the extension line of the corresponding electrode of the one lead line.

In an aspect of the present invention, the electron emission unit may be formed of one of a field emission array (FEA) electron emission element, a surface conduction emitter (SCE) electron emission element, a metal-insulation layer-metal (MIM) electron emission element, and a metal-insulation layer-semiconductor (MIS) electron emission element, or any combination thereof.

Further, a flat panel display according to another aspect of the present invention includes a plurality of pads, a substrate, an organic light emitting element, and a plurality of lead lines. A pixel area and a non-pixel area are defined in the substrate. The organic light emitting element is formed on the substrate and includes a plurality of electrodes and an organic emission layer. The plurality of lead lines respectively connects the plurality of pads to the plurality of electrodes. The lead lines are formed in a parallelogram shape in which resistivity and a line width are the same for each, and a length L and a line width W of each lead line are selected such that a value obtained by dividing the length L by the line width W may satisfy the equation

$$\frac{L_1}{W_1} = \frac{L_2}{W_2} = \frac{L_3}{W_3} = \ldots\ldots = \frac{L_n}{W_n},$$

where $L_1$, $L_2$, $L_3$, ..., and $Ln$ respectively refer to long side lengths, which are direct line distances between the respective electrode and the respective pad, of the respective lead lines formed in the parallelogram shape, and $W_1$, $W_2$, $W_3$, ..., and $Wn$ respectively refer to widths, which are short side distances of the respective lead lines formed in the parallelogram shape.

In an aspect of the present invention a line width Wn of one of the lead lines is selected to satisfy the equation $Wn = W_0 \sec\theta n$, where $W_0$ refer to a minimum line width of the one lead line when an inclination angle θ is 0 between the one lead line and an extension line of the corresponding electrode, and θn refers to an inclination angle θ of the one lead line and the extension line of the corresponding electrode of the one lead line.

In an aspect of the present invention, the flat panel display includes a thin film transistor. The thin film transistor includes an active layer, a gate electrode, a source electrode, and a drain electrode. The active layer and the gate electrode are sequentially disposed and the gate insulating layer is disposed between the active layer and the gate electrode. The source electrode and the drain electrode are disposed on the gate electrode and an interlayer insulating layer is disposed between the source electrode and the drain electrode.

According to another aspect of the present invention, a plurality of lead lines are formed on a substrate with a plurality of pads and a plurality of electrodes, wherein each lead line is connected to one of the plurality of pads and one of the plurality of electrodes, each lead line has substantially the same resistivity ρ and thickness t, and each lead line has a respective length L and a respective width W, and the ratio of the respective length L to the respective width W is substantially equal for each lead line.

In an aspect of the present invention, a plurality of lead lines formed on a substrate has a plurality of pads and a plurality of electrodes, wherein each lead line is connected to one of the plurality of pads and one of the plurality of electrodes, and each lead line has a respective length L and a respective width W, wherein at least one of the respective length L and the respective width W is selectively varied so that each lead line has substantially the same resistance.

In an aspect of the present invention, a plurality of lead lines formed on a substrate having a plurality of pads and a plurality of electrodes, wherein each lead line is connected to one of the plurality of pads and one of the plurality of electrodes, and each lead line has a respective length L and a respective width W, wherein as the respective length L is increased, the respective width W is increased.

According to another aspect of the present invention, a flat panel display comprises a plurality of electrodes arranged parallel to one another, a plurality of bundles, and a plurality of lead lines to respectively connect the plurality of pads to the plurality of electrodes. Each bundle comprises a plurality of pads having a uniform distance to an adjacent pad and the distance between outer pads of adjacent bundles is larger than the distance between adjacent pads of one bundle. The distance between adjacent pads of one bundle is different from the distance between adjacent electrodes. Each of the lead lines directly contacts an end portion of a respective pad and an end portion of a respective electrode. The line width of each of the lead lines is adapted such that the resistance of each of the plurality of lead lines of each bundle is the same. Additional aspects and/or advantages of the invention will be set forth in part in the description which follows and, in part, will be obvious from the description, or may be learned by practice of the invention.

## BRIEF DESCRIPTION OF THE DRAWINGS

These and/or other aspects and advantages of the invention will become apparent and more readily appreciated from the following description of the aspects, taken in conjunction with the accompanying drawings of which:

FIG. 1 is a partial exploded perspective view of a flat panel display according to an aspect of the present invention.
FIG. 2 is a cross-sectional view of the flat panel display shown in FIG. 1.
FIG. 3 is a top plan view of a portion of the flat panel display according to an aspect of the present invention.
FIG. 4 is a cross-sectional view of a lead line across IV-IV shown in FIG. 3.
FIG. 5 is a picture of a light emitting state of the flat panel display according to an aspect of the present invention.
FIG. 6 is a picture showing a light emitting state of a related flat panel display.
FIG. 7 is a top plan view representing one pixel in a flat panel display according to another aspect of the present invention.
FIG. 8 is a cross-sectional view across VIII-VIII shown in FIG. 7.

## DETAILED DESCRIPTION OF THE EMBODIMENTS

Reference will now be made in detail to the aspects of the present invention, examples of which are illustrated in the accompanying drawings, wherein like reference numerals refer to the like elements throughout. The aspects are described below in order to explain the present invention by referring to the figures.

In the figures, the dimensions of layers and regions may be exaggerated for clarity. It will also be understood that when a layer or element is referred to as being "on" or "over" another layer or substrate, it can be directly on the other layer or substrate, or intervening layers may also be present. Further, it will be understood that when a layer is referred to as being "under" or "below" another layer, it can be directly under, or one or more intervening layers may also be present.

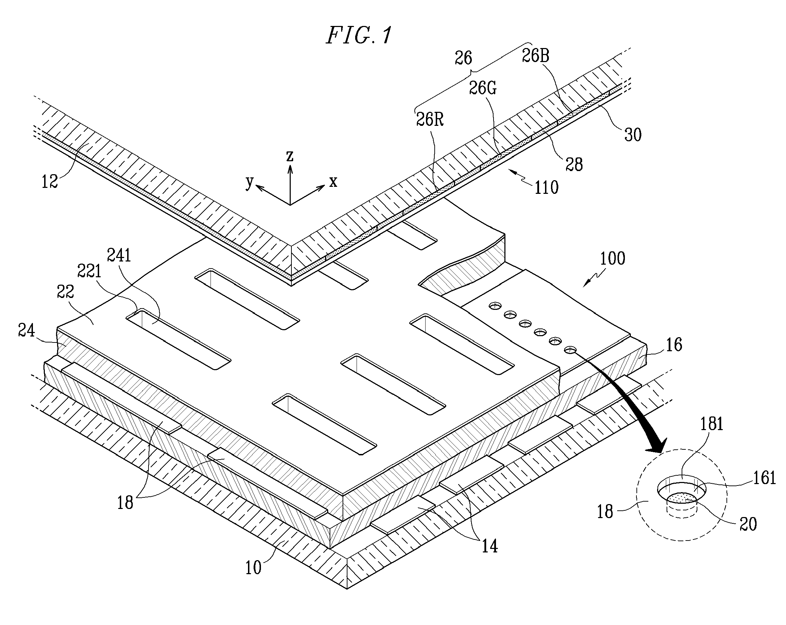

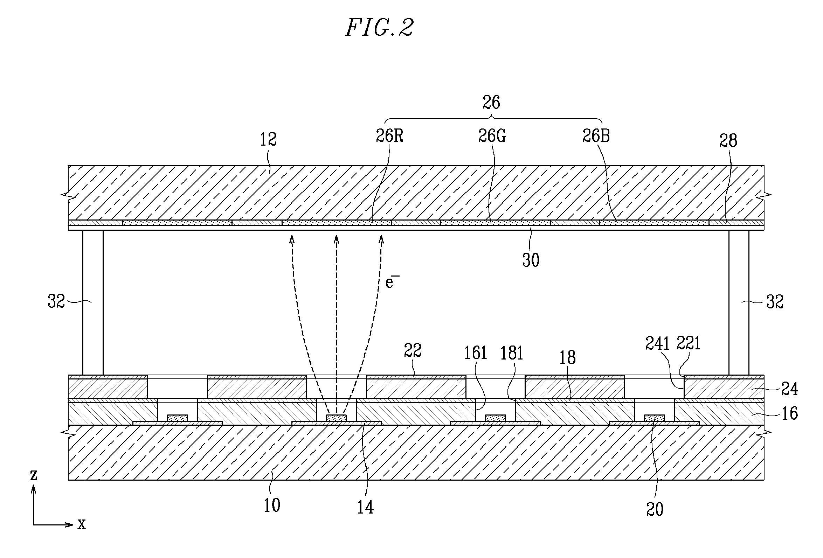

FIG. 1 is a partial exploded perspective view of a flat panel display according to an aspect of the present invention. FIG. 2 is a cross-sectional view of the flat panel display shown in FIG. 1. In FIG. 1, a field emission array type electron emission display is formed as a flat panel display. The flat panel display as shown may be an emissive display or may be a light source (e.g., a back light) of a non-emissive display, in various aspects.

As shown in FIG. 1 and FIG. 2, the flat panel display includes a first substrate 10 and a second substrate 12 that faces each other to include a predetermined space therebetween. A sealing member (not shown) is provided at an edge of the first substrate 10 and the second substrate 12 so as to bond the two substrates 10, 12. The first substrate 10, the second substrate 12, and the sealing member form a vacuum container in which a vacuum is maintained in the predetermined space. In various aspects, the vacuum may be at a pressure of $10^{-6}$ Torr (ca. $1.33 \cdot 10^{-4}$ Pa).

An electron emission unit 100 including electron emission elements is provided on one surface of the first substrate 10 that faces the second substrate 12, and a light emitting unit 110 to receive electrons in order to emit visible light is provided on one surface of the second substrate 12 that faces the first substrate 10. The electron emission unit 100, the light emitting unit 110, and the vacuum container form the flat panel display.

The electron emission unit 100 may be formed of an electron emission element, which may be one of a field emission array (FEA) type, a surface conduction emitter (SCE) type, a metal-insulation layer-metal (MIM) type, and a metal-insulation layer-semiconductor (MIS) type. The electron emission unit 100 emits electrons towards the light emitting unit 110. In FIG. 1 and FIG. 2, a field emission array type electron emission unit is shown by way of example. However, it is understood that the type of electron emission unit is not limited thereto.

In the flat panel display, as first electrodes, one or more cathode electrodes 14 are formed on the first substrate 10 along one direction of the first substrate 10 in a stripe pattern, and a first insulation layer 16 is formed on a surface of the first substrate 10 to cover the cathode electrodes 14. As second electrodes, one or more gate electrodes 18 are formed on the first insulation layer 16 in a striped pattern along a second direction substantially perpendicular to the first direction, so to cross the cathode electrodes 14 at a right angle.

In the shown aspect of the present invention, when a crossing region (or an overlapping region) of the cathode electrode 14 and the gate electrode 18 is defined as a pixel area, one or more electron emitters 20 are formed on the cathode electrodes 14 in each pixel area, and openings 161 and 181 that correspond to the respective electron emitters 20 are formed on the first insulation layer 16 and the gate electrode 18, respectively, so to expose the electron emitters 20.

The electron emitters 20 may be formed of materials that emit electrons when an electric field is applied in a vacuum state. Non-limiting examples of such materials include a carbon material or a nanometer-sized material (i.e. with a size ranging from 1 nm to 1000nm). The electron emitter 20 may include carbon nano-tubes (CNTs), graphite, graphite nano-fiber, diamond, diamond-like-carbon (DLC), fullerene (C60), silicon nano-wire, or a combination thereof. The electron emitter 20 may be manufactured using a screen print method, a direct attachment method, a sputtering method, a chemical vapor deposition (CVD) method, other methods, or combinations thereof.

As a third electrode, a focusing electrode 22 may be formed on the gate electrodes 18. A second insulation layer 24 is positioned under the focusing electrode 22 to insulate the gate electrodes 18 from the focusing electrode 22, and openings 221 and 241 are provided on the focusing electrode 22 and the second insulation layer 24, respectively, to transmit an electron beam.

The focusing electrode 22 forms (or includes) one opening for one or more electron emitters 20 to focus the electrons emitted from each of the electron emitters 20. Accordingly, the focusing electrode 22 forms (or includes) one opening for each pixel area to focus the electrons emitted for the one pixel area, as shown, in FIG. 2.

The light emitting unit 110 will now be described. A phosphor layer 26 including red 26R, green 26G, and blue 26B phosphor layers is formed on one surface of the second substrate 12 that faces the first substrate 10. As shown, the red 26R, green 26G, and blue 26B phosphors are arranged with predetermined intervals therebetween. Also, a dark colored layer 28 is formed between the respective red 26R, green 26G, and blue 26B phosphor layers to improve screen contrast therebetween. In addition, an anode electrode 30 formed of a metal, for example, is formed on the phosphor layer 26 and the dark colored layer 28. In various aspects, the metal of the anode electrode 30 may be aluminum. In other aspects, other types of metals are within the scope of the invention for the anode electrode 30. Additionally, materials other than metals are within the scope of the invention for the anode electrode 30.

In the aspect shown, the anode electrode 30 externally receives a high voltage to maintain the phosphor layer 26 in a high potential state, and to accelerate an electron beam. The anode electrode 30 reflects visible light that is reflected toward the first substrate 10, that are emitted from the phosphor layer 26, back toward the second substrate 12, to increase screen luminance thereof.

In various aspects, the anode electrode 30 may be formed of a transparent conductive layer (e.g., indium tin oxide). In this case, the anode electrode 30 is positioned on surfaces of the phosphor layer 26 and the dark colored layer 28 facing the second substrate 12. Further, in other aspects, the anode electrode 30 may be formed of a combination of the metal layer and the transparent conductive layer.

As shown in FIG. 2, a plurality of spacers 32 is provided between the first substrate 10 and the second substrate 12 to maintain the space between the two substrates 10, 12 and to support the two substrates 10, 12 against a compressive force applied to the vacuum container. The spacers 32 are positioned to correspond to the dark colored layer 28 so as to not intrude upon the phosphor layer 26.

The flat panel display externally receives voltages to drive the cathode electrodes 14, the gate electrodes 18, the focusing electrode 22, and the anode electrodes 30. In addition, electrode pads 34 to apply voltages from an external power source to the respective electrodes (e.g., the cathode electrodes 14, the gate electrodes 18, the focusing electrode 22, and/or the anode electrodes 30) are positioned on edges of the first substrate 10 and/or the second substrate 12. The electrode pad 34 will now be described in further detail.

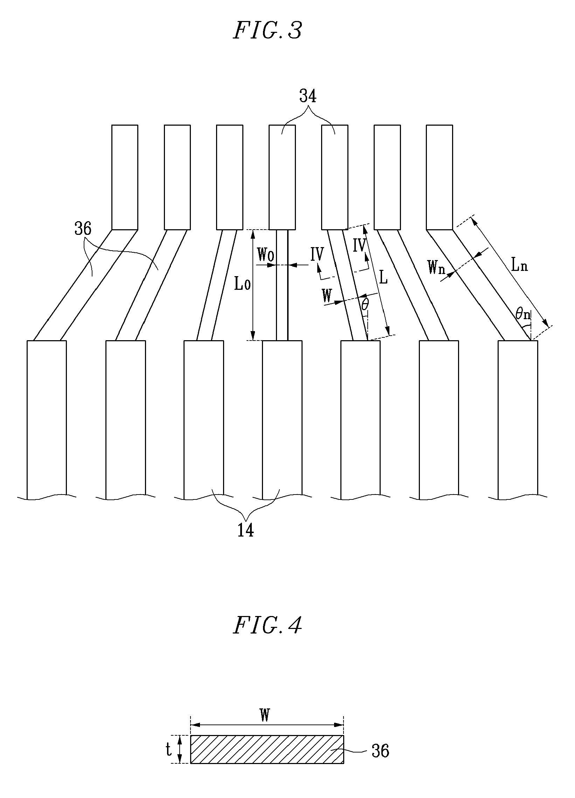

FIG. 3 is a top plan view of a portion of the flat panel display according to an aspect of the present invention. FIG. 4 is a cross-sectional view across IV-IV shown in FIG. 3. In FIG. 3, for convenience of description, a lead line 36 and an electrode pad 34 (hereinafter referred to as a "pad") for the cathode electrode 14 are illustrated among the electrodes (e.g., the cathode electrodes 14, the gate electrodes 18, the focusing electrode 22, and/or the anode electrodes 30) shown in FIG. 1 and FIG. 2. However, it should be understood that in other aspects, the other electrodes may be connected to a lead line and an electrode pad.

As shown in FIG. 3, for example, the lead line 36 is formed between the cathode electrode 14 and the pad 34 to electrically connect the cathode electrode 14 and the pad 34. Each lead line 36 may be formed to be (or outlined) in a shape of a parallelogram and to have the same resistivity ρ and film thickness (or thickness) t, though not required. In other aspects, each lead line 36 may be formed to be (or outlined) in a shape of a polygon. Although discussed in terms of the same resistivity ρ and film thickness t, in various aspects, the film thickness t may vary, along with a length L and a width W thereof.

In the aspect shown, total resistance R of one lead line 36 is given by Equation 1.

[Equation 1]

$$R = \rho \frac{L}{W \times t},$$

where ρ refers to the resistivity of the lead line 36, L refers to the length of the lead line 36, W refers to a line width (or width) of the lead line 36, and t refers to the film thickness of the lead line 36. In various aspects, the resistivity ρ is varied depending on the material of the lead line 36.

As shown, when the resistivity ρ and the film thickness t of the lead line 36 are maintained at a predetermined level (or value), the total resistance R is in proportion (or proportional) to the length L and in inverse-proportion (or inversely proportional) to the line width W. Accordingly, when the length L and the line width W of each lead line 36 are appropriately (or selectively) established, the resistance R of all the lead lines 36 may be maintained (selected or set) at a predetermined level (or value).

In various aspects, the resistivity ρ is determined by (or dependent upon) a material that forms the lead line 36. Accordingly, if the same materials are used to form the lead lines 36, the same resistivity ρ may be maintained (or obtained). The film thickness t of the lead line 36 may be uniformly maintained (or obtained) within a predetermined error range (or a predetermined margin of error) by using a highly precise vapor deposition or print method.

The flat panel display according to an aspect of the present invention has one or more lead lines 36 that are (or whose outlines are) formed in a parallelogram-like shape or configuration to efficiently control the length L and the line width W of the lead line 36, and to efficiently connect the cathode electrode 14 and the pad 34. In various aspects, the lead line or lines 36 are formed in a slope direction (or at an incline) to connect the cathode electrode 14 and the pad 34 that are offset or not linearly aligned, for example. However, it is understood that one or more lead lines 36 may be curved, angled, bent, or in any other shape, in other aspects.

The length L of the lead line 36 indicates a direct line distance between the cathode electrode 14 and the corresponding pad 34, and the length L corresponds to a long side length (or length direction) when the lead line 36 is formed in the parallelogram shape (or an outline thereof). In various aspects, the line width W of the lead line 36 corresponds to a distance of a short side direction (or width) of the parallelogram (or an outline thereof).

In the flat panel display according to this aspect of the present invention, the length L and the line width W of each lead line 36 are respectively established (or selected) to maintain a same value (or ratio) when each length L is divided by the corresponding line width W so that the resistance R of all the lead lines 36 may be maintained at a predetermined level.

That is, the respective lead lines 36 of n cathode electrodes 14 are all set to satisfy the same (or substantially the same) resistance R of Equation 2, and a ratio of the length L and the line width W of the respective lead lines 36 is set to satisfy Equation 3.

[Equation 2]

$$R_1 = R_2 = R_3 = \ldots\ldots = R_n,$$

where R1, R2, R3, ..., and Rn respectively refer to the resistance of the lead lines 36.

[Equation 3]

$$\frac{L_1}{W_1} = \frac{L_2}{W_2} = \frac{L_3}{W_3} = \cdots\cdots = \frac{L_n}{W_n},$$

where L1, L2, L3, ..., and Ln respectively refer to the long side lengths (or lengths) of the respective lead lines 36 formed in the parallelogram shape (or having the parallelogram outline), and W1, W2, W3, ..., and Wn respectively refer to the short side distances (or widths) of the respective lead lines 36 formed in the parallelogram shape (or having the parallelogram outline).

In addition, the line width Wn according to an inclination angle θn of each lead line 36 is given as Equation 4. As shown, the inclination angle θn refers to an angle between the longitudinal direction of a cathode electrode 14 and the longitudinal direction of the corresponding lead line 36.

[Equation 4]

$$Wn = W_0 \sec\theta n,$$

where W0 refers to a minimum line width of the lead line 36 corresponding to an inclination angle θ = 0. In various aspects, the inclination angle θ may be based on an extension line that extends from the pad 34.

As shown in FIG. 3, the length L of a particular lead line 36 is fixed based on a position of the corresponding electrode pad 34 relative to the other pads 34. Accordingly, the line width W of each lead line 36 may be varied for each lead line 36 in such a way that all lead lines have the same (or substantially the same) resistance R. That is, the location of the electrode pad 34 relative to the other pads on the flat panel display affects the length L and/or the width W of the lead lines 36.

That is, when a mounting position of the electrode pad 34 and an end terminal position of the cathode electrode 14 are established (or set) on the flat panel display, the length L of the lead line 36, which is a distance between the electrode pad 34 and the cathode electrode 14, can be determined (or set) to be a predetermined value based on the mounting position of lead line 36, the corresponding electrode pad 34 and/or the corresponding cathode electrode 14. Accordingly, the line width W of the lead line 36 is selectively determined according to the length L of the lead line 36 so that each of the respective lead lines 36 has the same resistance.

If a minimum length L0 refers to a length of the lead line 36 when the inclination angle θ of the lead line 36 is 0, and the minimum line width W0 is the line width of the lead line 36 having the minimum length L0, a length Ln and a line width Wn of an nth lead line are given as Equation 5 derived from Equation 3.

[Equation 5]

$$\frac{L_0}{W_0} = \frac{L_n}{W_n}$$

If θn refers to the inclination angle between the nth lead line and the extension line of the corresponding electrode, the length Ln of the nth lead line 36 is given as Equation 6 by using the length L0 given when the inclination angle θ is 0.

[Equation 6]

$$L_n = L_0 \times \sec\theta_n$$

Accordingly, Equation 4 is obtained by substituting Equation 6 into Equation 5.

In the flat panel display according to this aspect of the present invention, if an end position of the cathode electrode 14 and the position of the electrode pad 34 are established (or set) on the flat panel display, the inclination angle θ of each corresponding lead line 36 becomes established or set. Also, if an end position of the cathode electrode 14 and the position of the electrode pad 34 are established (or set) on the flat panel display, the minimum line width W0 of the lead line 36 (which is the width of the lead line 36 when the inclination angle θ is 0) is determined or set. Accordingly, the line width W of each lead line 36 is determined or set thereby.

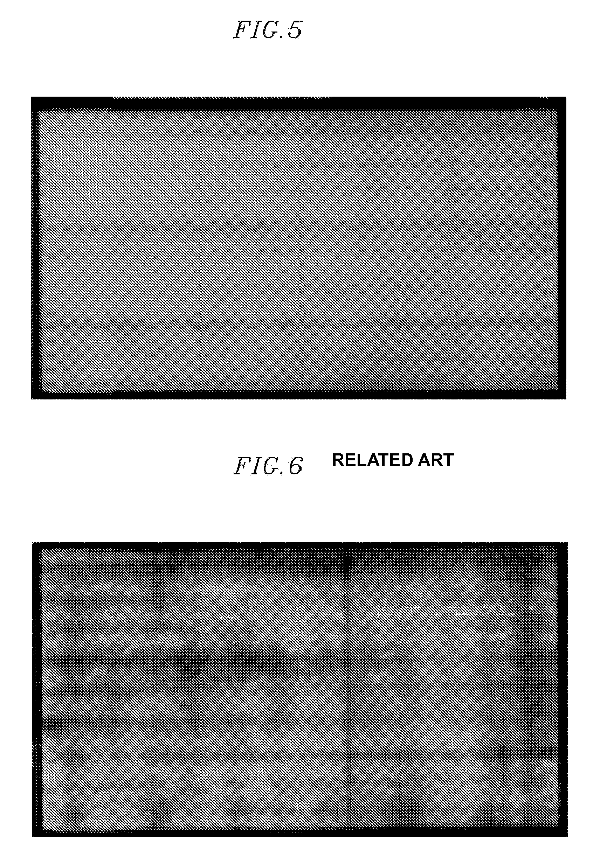

FIG. 5 is a picture of a light emitting state of the flat panel display according to an aspect of the present invention in which the lead line 36 is formed as described above. In a related flat panel display shown in FIG. 6, widths of the lead lines are uniform throughout and black oblique lines are shown by luminance differences therein. However, in the flat panel display according to this aspect of the present invention, the oblique lines are not shown, and uniform luminance may be obtained. In this aspect of the present invention, while the lead line of the cathode electrodes is shown by way of example, aspects of the present invention are not limited thereto. In other aspects, the lead line may be applied to the gate electrodes, the focusing electrode, and/or the anode electrode.

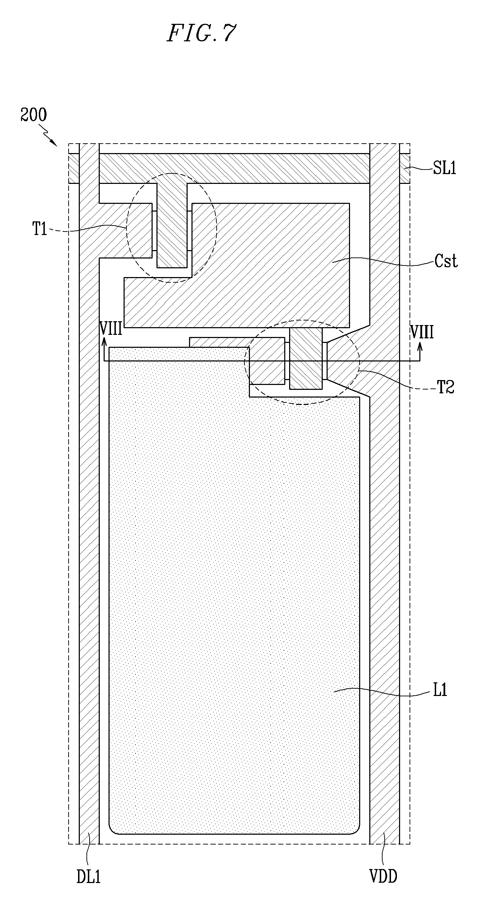

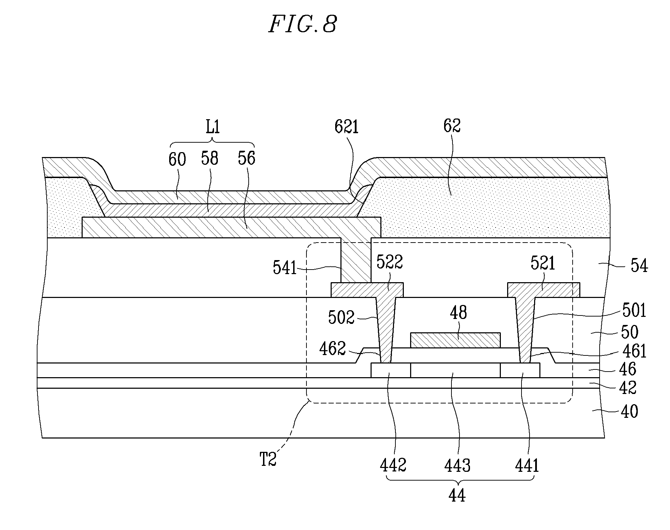

FIG. 7 is a top plan view representing one pixel in the flat panel display according to another aspect of the present invention. FIG. 8 is a cross-sectional view across VIII-VIII shown in FIG. 7. The flat panel display according to this aspect of the present invention is an organic light emitting diode (OLED) display. The flat panel display according to this aspect includes a pixel area (not shown in its entirety), in which an image is displayed on the substrate 40, and a non-pixel area (not shown) is positioned outside the pixel area. As a basic image display unit, each pixel 200 is arranged in a matrix format in the pixel area.

Referring to FIG. 7, each pixel 200 may include a first thin film transistor T1, a second thin film transistor T2, and an organic light emitting element L1. The first thin film transistor T1 is connected to a scan line SL1 and a data line DL1, and transmits a data voltage from the data line DL1 to the second thin film transistor T2 according to a switching voltage input to the scan line SL1. A storage capacitor Cst is connected to the first thin film transistor T1 and a power source line VDD to store a voltage Vgs corresponding to a difference between a voltage transmitted from the first thin film transistor T1 and a voltage supplied to the power source line VDD.

The second thin film transistor T2 is connected to the power source line VDD and the storage capacitor Cst to supply an output current Id corresponding to a square of a difference between the voltage Vgs stored in the storage capacitor Cst and a threshold voltage Vth to the organic light emitting element L1, and the organic light emitting element L1 emits a light by way of the output current Id. In this case, the output current Id is given as Equation 7. In Equation 7, β refers to a proportional constant (or a proportionality constant).

[Equation 7]

$$I_d = (\beta/2) \times (V_{gs} - V_{th})^2$$

Configurations (or layout) of the second thin film transistor T2, the storage capacitor Cst, and the organic light emitting element L1 will be described with reference to FIG. 8. The configuration of the thin film transistor will be discussed using the structures of the second thin film transistor T2 by way of example. Since the first thin film transistor T1 has the same configuration as that of the second thin film transistor T2, a detailed description thereof will not be repeated.

As shown, a buffer layer 42 is formed on the substrate 40, and an active layer 44 is formed on the buffer layer 42. The active layer 44 includes source and drain areas 441 and 442, and a channel area 443 between the source and drain areas 441 and 442. A gate insulating layer 46 is formed on the buffer layer 42 to cover the active layer 44, and a gate electrode 48 is formed on the gate insulating layer 46. An interlayer insulating layer 50 is formed on the gate insulating layer 46 to cover the gate electrode 48, and source and drain electrodes 521 and 522 are formed on the interlayer insulating layer 50. The source and drain electrodes 521 and 522 are electrically connected to the source and drain areas 441 and 442, respectively, through respective first contact holes 461, 501 and respective second contact holes 462, 502. The first contact holes 461, 501 and the second contact holes 462, 502 are provided through the gate insulating layer 46 and the interlayer insulating layer 50, respectively.

As shown, the substrate 40 may be formed of an insulation material or a metallic material. In various aspects, glass or plastic may be used as the insulation material while stainless steel (SUS) may be used as the metallic material. The buffer layer 42 prevents or reduces diffusion of impurities relative to the substrate 40 when forming the active layer 44. The buffer layer 42 may be formed of a laminated layer including a silicon nitride (SiN) layer and/or a silicon oxide (SiO2) layer. The gate electrode 48 may be formed of a metal layer. In various aspects, the metal layer may be one of a MoW layer, an Al layer, a Cr layer, and an Al/Cr layer or any combinations thereof. The source and drain electrodes 521 and 522 may be formed of a metal layer, though not required. In various aspects, the metal layer may be a Ti/Al layer or a Ti/Al/Ti layer.

A planarization layer 54 is formed on the interlayer insulating layer 50 to cover the second thin film transistor T2. While not illustrated, a protective layer may be further formed between the planarization layer 54 and the interlayer insulating layer 50 to protect the second thin film transistor T2. A first pixel electrode 56 is electrically connected to the drain electrode 522 of the second thin film transistor T2 through a via hole 541 provided to the planarization layer 54. An organic emission layer 58 and a second pixel electrode 60 are sequentially accumulated (or formed) on the first pixel electrode 56 to form the organic light emitting element L1. In addition, the first pixel electrode 56 is electrically separated from a first pixel electrode (not shown) of a neighboring pixel by a pixel definition layer 62, and contacts the organic emission layer 58 through an opening 621 provided to the pixel definition layer 62. As shown, the first pixel electrode 56 injects holes, and the second pixel electrode 60 injects electrons.

The first pixel electrode 56 may be formed of a first transparent electrode. The first transparent electrode may include indium tin oxide and/or indium zinc oxide. The first transparent layer may further include a conductive reflective layer (not shown) and a second transparent electrode (not shown) on the first transparent electrode along a light emitting direction of the organic light emitting element L1.

The reflective layer reflects light from the organic emission layer 58 to increase luminous efficiency, and improves electrical conductivity. The reflective layer may be formed of aluminum, an aluminum alloy, silver, a silver alloy, gold, a gold alloy, other materials, or any combinations thereof.

The second transparent electrode suppresses oxidization of the reflective layer to improve a work function relationship between the organic emission layer 58 and the reflective layer. The second transparent electrode may be formed of the indium tin oxide and/or the indium zinc oxide in a like manner as the first transparent electrode.

The organic emission layer 58 may further include an emission layer to emit light and a multi-layered organic layer positioned on an upper part and a lower part of the emission layer to efficiently transmit carriers, such as holes and electrons, to the emission layer. For example, a hole injection layer and a hole transmission layer may be further provided between the first pixel electrode 56 and the emission layer, and an electron transmission layer and an electrode injection layer may be provided between the emission layer and the second pixel electrode 60.

The flat panel display according to this aspect of the present invention includes electrode pads (not shown) to apply voltages from an external power source (not shown) to the scan line SL1, data line DL1, and the second pixel electrode 60. In addition, a lead line (not shown) is provided between the scan and data lines SL1 and DL1, the second pixel electrode 60, and the electrode pads to electrically connect the scan and data lines SL1 and DL1, the second pixel electrode 60, and the electrode pads.

A configuration of the lead line according to the second aspect of the present invention is the same as that of the first aspect of the present invention, and therefore detailed descriptions thereof will not be repeated.

According to the flat panel display according to aspects of the present invention, since the length and line width of the lead line are appropriately established, resistance of the lead line may be maintained at a predetermined level, and a luminance difference between each lead line that may be caused by a resistance difference of each lead line may be eliminated or reduced.

**Claims**

1. A flat panel display comprising:

   a plurality of electrodes (14, SL1, DL1) arranged parallel to one another;
   a plurality of bundles, wherein each bundle comprises plurality of pads (34) having a uniform distance to an adjacent pad (34) and wherein the distance between outer pads (34) of adjacent bundles is larger than the distance between adjacent pads (34) of one bundle; and
   a plurality of lead lines (36) to respectively connect the plurality of pads (34) to the plurality of electrodes (14, SL1, DL1);

   wherein each of the lead lines (36) directly contacts both, an end portion of a respective pad (34) and an end portion of a respective electrode (14, SL1, DL1);
   wherein the distance between adjacent pads (34) of one bundle is different from the distance between adjacent electrodes (14, SL1, DL1);
wherein each of the lead lines (36) in one bundle is formed in a parallelogram shape;
wherein the resistivity and/or the line thickness (t) are the same for each of the plurality of lead lines (36) in a bundle; and
**characterized in that**
the line width (W, $W_0$, $W_n$) of each of the lead lines (36) is adapted such that the resistance of each of the plurality of lead lines (36) of each bundle is the same, and
a length L and a line width W of each lead line (36) are adapted to satisfy the equation

$$\frac{L_1}{W_1} = \frac{L_2}{W_2} = \frac{L_3}{W_3} = \ldots\ldots = \frac{L_n}{W_n},$$

where, $L_1$, $L_2$, $L_3$, ..., $L_n$ respectively refer to long side lengths, which are direct line distances between the corresponding electrode (14, SL1, DL1) and the corresponding pad (34) and $W_1$, $W_2$, $W_3$, ..., $W_n$ respectively refer to widths, which are short side distances measured along a direction perpendicular to the long side length of the respective lead lines (36).

2. The flat panel display according to claim 1, wherein the plurality of lead lines (36) of one bundle are arranged in an isosceles trapezoid shape and/or the longitudinal axes of plurality of electrodes (14, SL1, DL1) are parallel to the longitudinal axes of the plurality of pads (34).

3. The flat panel display according to one of the preceding claims, wherein the plurality of pads (34) of each bundle is directly connected to a flexible printed circuit or to a flexible printed circuit board assembly which is adapted to apply a driving voltage to the electrodes (14, SL1, DL1).

4. The flat panel display according to one of the preceding claims, wherein the line width Wn of one of the lead lines (36) is selected to satisfy the equation:

$$W_n = W_0 \cdot \sec\theta_n,$$

where $W_0$ refers to a minimum line width of the one lead line (36) having an inclination angle $\theta$ equal to 0, and $\theta_n$ refers to the inclination angle $\theta$ of the n-th lead line (36),
wherein the inclination angle $\theta$ refers to an angle between the longitudinal direction of the lead line (36) and the longitudinal direction of the corresponding electrode (14, SL1, DL1).

5. The flat panel display according to one of claims 1-4, further comprising:

first and second substrates (10, 12) facing each other;
an electron emission unit (100) disposed on one surface of the first substrate (10) facing the second substrate (12) and including a plurality of electrodes (14, 16, 18) and a plurality of pads (34); and
a light emitting unit (110) disposed on one surface of the second substrate (12) facing the first substrate (10).

6. The flat panel display according to one of claims 1-4, further comprising:

a substrate (40) in which a pixel area and a non-pixel area are defined; and
an organic light emitting element (L1) that is formed on the substrate (40) and includes a plurality of electrodes (60, 56) and an organic emission layer (58).

7. The flat panel display of claim 6, further comprising a thin film transistor (T1, T2) formed on the pixel area, wherein the thin film transistor (T1, T2) comprises:

an active layer (44);
a gate electrode (48) disposed on the active layer (44);
a gate insulating layer (46) disposed between the active layer (44) and the gate electrode (48);
a source electrode (521) and a drain electrode (522) disposed on the gate electrode (48); and
an interlayer insulating layer (50) disposed between the source electrode (521) and the drain electrode (522).

**Amended claims in accordance with Rule 137(2) EPC.**

1. A flat panel display comprising:

a plurality of electrodes (14, SL1, DL1) arranged parallel to one another;
a plurality of bundles, wherein each bundle comprises plurality of pads (34) having a uniform distance to an adjacent pad (34) and wherein the distance between outer pads (34) of adjacent bundles is larger than the distance between adjacent pads (34) of one bundle; and
a plurality of lead lines (36) to respectively connect the plurality of pads (34) to the plurality of electrodes (14, SL1, DL1);

wherein each of the lead lines (36) directly contacts both, an end portion of a respective pad (34) and an end portion of a respective electrode (14, SL1, DL1);

wherein the distance between adjacent pads (34) of one bundle is different from the distance between adjacent electrodes (14, SL1, DL1);
wherein each of the lead lines (36) in one bundle is formed in a parallelogram shape;
wherein the resistivity and/or the line thickness (t) are the same for each of the plurality of lead lines (36) in a bundle; and
the line width ($W$, $W_0$, $W_n$) of each of the lead lines (36) is adapted such that the resistance of each of the plurality of lead lines (36) of each bundle is the same, and
a length L and a line width W of each lead line (36) are adapted to satisfy the equation

$$\frac{L_1}{W_1} = \frac{L_2}{W_2} = \frac{L_3}{W_3} = \ldots\ldots = \frac{L_n}{W_n},$$

where, $L_1$, $L_2$, $L_3$, ..., $L_n$ respectively refer to long side lengths, which are direct line distances between the corresponding electrode (14, SL1, DL1) and the corresponding pad (34) and $W_1$, $W_2$, $W_3$, ..., $W_n$ respectively refer to widths, which are short side distances measured along a direction perpendicular to the long side length of the respective lead lines (36),

**characterized in that**
the number of lead lines per bundle ranges from 4 to 10.

**2.** The flat panel display according to claim 1, wherein the plurality of lead lines (36) of one bundle are arranged in an isosceles trapezoid shape and/or the longitudinal axes of plurality of electrodes (14, SL1, DL1) are parallel to the longitudinal axes of the plurality of pads (34).

**3.** The flat panel display according to one of the preceding claims, further comprising a flexible printed circuit or a flexible printed circuit board assembly which is adapted to apply a driving voltage to the electrodes (14, SL1, DL1), wherein the plurality of pads (34) of each bundle is directly connected to the flexible printed circuit or to the flexible printed circuit board assembly.

**4.** The flat panel display according to one of the preceding claims, wherein the line width Wn of one of the lead lines (36) is selected to satisfy the equation:

$$W_n = W_0 \cdot \sec\theta_n ,$$

where $W_0$ refers to a minimum line width of the one lead line (36) having an inclination angle $\theta$ equal to 0, and $\theta_n$ refers to the inclination angle $\theta$ of the n-th lead line (36),

wherein the inclination angle $\theta$ refers to an angle between the longitudinal direction of the lead line (36) and the longitudinal direction of the corresponding electrode (14, SL1, DL1).

**5.** The flat panel display according to one of claims 1-4, further comprising:

first and second substrates (10, 12) facing each other;
an electron emission unit (100) disposed on one surface of the first substrate (10) facing the second substrate (12) and including a plurality of electrodes (14, 16, 18) and a plurality of pads (34); and
a light emitting unit (110) disposed on one surface of the second substrate (12) facing the first substrate (10).

**6.** The flat panel display according to one of claims 1-4, further comprising:

a substrate (40) in which a pixel area and a non-pixel area are defined; and
an organic light emitting element (L1) that is formed on the substrate (40) and includes a plurality of electrodes (60, 56) and an organic emission layer (58).

**7.** The flat panel display of claim 6, further comprising a thin film transistor (T1, T2) formed on the pixel area, wherein the thin film transistor (T1, T2) comprises:

an active layer (44);
a gate electrode (48) disposed on the active layer (44);
a gate insulating layer (46) disposed between the active layer (44) and the gate electrode (48);

a source electrode (521) and a drain electrode (522) disposed on the gate electrode (48); and

an interlayer insulating layer (50) disposed between the source electrode (521) and the drain electrode (522).

FIG. 1

## FIG.2

EP 1 975 688 A1

*FIG.3*

*FIG.4*

## FIG.5

## FIG.6   RELATED ART

## FIG.7

FIG.8

EP 1 975 688 A1

**European Patent Office**

**EUROPEAN SEARCH REPORT**

Application Number

EP 07 11 9848

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 104 465 A (NA BYOUNG-SUN [KR] ET AL) 15 August 2000 (2000-08-15) | 1-4 | INV. G02F1/1345 |
| Y | * column 3, line 55 - column 4, line 4; figure 4 * | 5-7 | |
| | ----- | | |
| Y | US 2006/232738 A1 (LIN TUNG-LIANG [TW] ET AL) 19 October 2006 (2006-10-19) * paragraph [0025]; figure 1 * ----- | 5-7 | |

TECHNICAL FIELDS
SEARCHED (IPC)

G02F
H05K

The present search report has been drawn up for all claims

| Place of search | Date of completion of the search | Examiner |
|---|---|---|
| The Hague | 23 May 2008 | Degroote, Bart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 9848

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2008

| Patent document cited in search report | | Publication date | Patent family member(s) | | Publication date |
|---|---|---|---|---|---|
| US 6104465 | A | 15-08-2000 | NONE | | |
| US 2006232738 | A1 | 19-10-2006 | JP | 2006309224 A | 09-11-2006 |
| | | | KR | 20060110200 A | 24-10-2006 |

EPO FORM P0459

For more details about this annex : see Official Journal of the European Patent Office, No. 12/82